(19) Europäisches Patentamt
European Patent Office
Office européen des brevets

(11) **EP 3 176 881 B1**

(12) **FASCICULE DE BREVET EUROPEEN**

(45) Date de publication et mention
de la délivrance du brevet:
**15.08.2018 Bulletin 2018/33**

(51) Int Cl.:
***H01R 13/03*** *(2006.01)*    *H01R 31/08* *(2006.01)*
*H01R 101/00* *(2006.01)*    *H01H 9/52* *(2006.01)*

(21) Numéro de dépôt: **16201886.5**

(22) Date de dépôt: **02.12.2016**

(54) **CONNECTEUR ÉLECTRIQUE COMPORTANT UN DISSIPATEUR THERMIQUE ET APPAREIL ÉLECTRIQUE ÉQUIPÉ D'UN TEL CONNECTEUR**

ELEKTRISCHER ANSCHLUSS, DER EINEN KÜHLKÖRPER UMFASST, UND ELEKTRISCHES GERÄT, DAS MIT EINEM SOLCHEN ANSCHLUSS AUSGESTATTET IST

ELECTRICAL CONNECTOR COMPRISING A THERMAL DISSIPATOR AND ELECTRICAL APPARATUS EQUIPPED WITH SUCH A CONNECTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2015 FR 1561754**

(43) Date de publication de la demande:
**07.06.2017 Bulletin 2017/23**

(73) Titulaire: **Schneider Electric Industries SAS
92500 Rueil-Malmaison (FR)**

(72) Inventeurs:
• **BLANCHET, Matthieu
38050 GRENOBLE Cedex 09 (FR)**
• **SPEZZATTI, Patricia
38050 GRENOBLE Cedex 09 (FR)**
• **KILINDJIAN, Christophe
38050 GRENOBLE Cedex 09 (FR)**
• **DOMEJEAN, Eric
38050 GRENOBLE Cedex 09 (FR)**

(74) Mandataire: **Lavoix
62, rue de Bonnel
69448 Lyon Cedex 03 (FR)**

(56) Documents cités:
**EP-A1- 2 280 460        WO-A1-2007/149535
WO-A1-2013/143657        CN-U- 204 011 306
DE-A1- 10 055 454        US-A1- 2002 122 289
US-A1- 2006 245 987        US-A1- 2013 032 322**

EP 3 176 881 B1

**Description**

La présente invention concerne un connecteur électrique et un disjoncteur équipé d'un tel connecteur.

Les disjoncteurs prévus pour des courants alternatifs à basse tension comprennent en général plusieurs pôles, fréquemment trois ou quatre pôles. Chaque pôle est propre à recevoir, sur une plage de connexion d'entrée, une phase du courant alternatif ou le neutre et pour délivrer, en fonctionnement normal, la phase sur une plage de sortie. Le disjoncteur est, en outre, propre à isoler en cas de besoin la plage d'entrée de la plage de sortie, c'est-à-dire propre à bloquer le passage du courant à travers le pôle.

Un tel disjoncteur présente une résistance non négligeable au passage du courant, ce qui peut entraîner un échauffement important de ses organes internes. La chaleur générée est dissipée en grande partie dans les câbles connectés électriquement aux plages d'entrée et de sortie, les câbles jouant ainsi le rôle de dissipateurs thermiques grâce à leur grande conductivité thermique et leur grande longueur.

Les disjoncteurs de ce type sont utilisés pour des applications en courant continu pouvant atteindre 1500 Volt. Par exemple, les sources d'énergie solaire du type photovoltaïque fournissent des tensions continues pouvant aller jusqu'à 1500 Volts (V) environ. Cependant, les pôles de ces disjoncteurs ne conviennent pas à des tensions supérieures à 500 V environ. Afin d'utiliser de tels disjoncteurs à une tension plus élevée, différents pôles sont en général mis en série à l'aide de connecteurs électriques. La tension est alors répartie sur plusieurs pôles du disjoncteur, chaque pôle étant soumis à une tension électrique inférieure ou égale à 500 V.

De tels connecteurs électriques présentent fréquemment une forme proche de celle de la lettre U, et permettent de connecter électriquement les plages d'entrée (ou de sortie) de deux pôles voisins.

Lorsqu'une telle configuration est utilisée, la dissipation de la chaleur générée dans le disjoncteur est rendue plus difficile au niveau des connecteurs. En effet, chaque pôle, au lieu d'être relié à un câble électrique jouant le rôle de dissipateur thermique, est relié à au moins un autre pôle dans lequel le courant électrique provoque un échauffement. Le risque de dégradation du disjoncteur par échauffement est donc augmenté.

Afin de pallier ces effets, les connecteurs utilisés sont fréquemment équipés de dispositifs de refroidissement, tels que des ailettes, augmentant la surface d'échange entre le connecteur et l'atmosphère. Le document CN 204 011 306 U divulgue un connecteur électrique selon le préambule de la revendication 1. Cependant, les dispositifs de refroidissement utilisés ne sont pas très efficaces. En particulier, les dispositifs de refroidissement utilisés ne conviennent pas à toutes les orientations possibles pour le disjoncteur, car ils nécessitent que les ailettes soient disposées verticalement de façon à maximiser les échanges convectifs avec l'atmosphère.

L'objectif de l'invention est de proposer un connecteur électrique, propre à permettre la mise en série de deux pôles d'un disjoncteur, qui présente une plus grande efficacité en termes de dissipation thermique.

A cet effet, l'invention a pour objet un connecteur électrique selon la revendication 1.

Suivant d'autres aspects avantageux de l'invention, le connecteur est conforme à l'une quelconque des revendications 2 à 5.

L'invention a également pour objet un appareil électrique, notamment disjoncteur, selon la revendication 6.

Les caractéristiques et avantages de l'invention apparaîtront à la lecture de la description qui va suivre, donnée uniquement à titre d'exemple non limitatif, et faite en référence aux dessins annexés, sur lesquels :

- la figure 1 est une vue en perspective éclatée d'un disjoncteur muni de deux connecteurs conformes à l'invention,
- la figure 2 est une vue de dessus et en perspective d'un connecteur du disjoncteur de la figure 1,
- la figure 3 est une vue de face selon la flèche B1 du connecteur de la figure 1, et
- la figure 4 est une vue de côté selon la flèche B2 du connecteur de la figure 1.

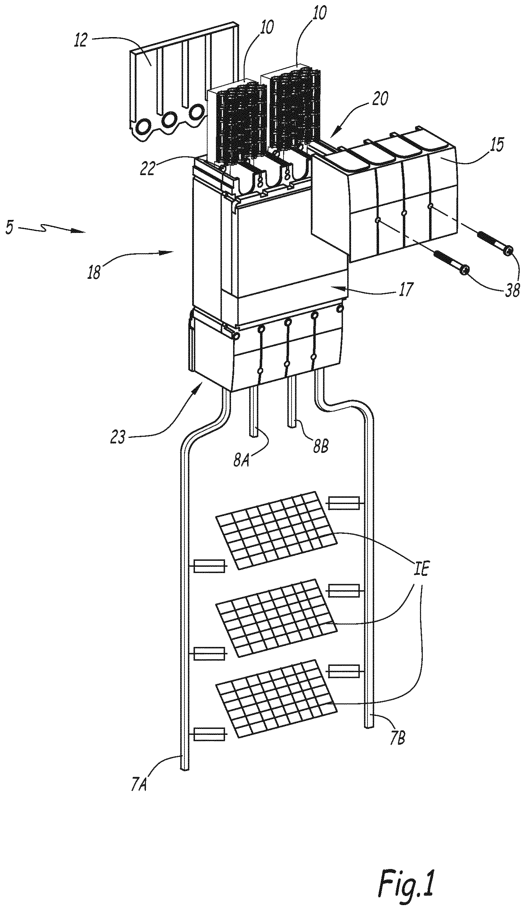

Un appareil électrique 5 équipé de deux conducteurs d'entrée 7A, 7B, de deux conducteurs de sortie 8A, 8B, de deux connecteurs 10, d'une base arrière 12 et d'un capot 15 est représenté sur la figure 1.

L'appareil électrique 5 est, par exemple, un disjoncteur, tel qu'un disjoncteur électromécanique.

Le disjoncteur 5 est de forme globalement parallélépipédique.

Le disjoncteur 5 présente une face avant 17, une face arrière (non représentée), deux faces latérales 18 dont une seule est visible sur la gauche de la figure 1, et deux faces terminales 20 dont seule la face supérieure est visible en partie haute de la figure 1.

Le disjoncteur 5 présente une pluralité de pôles. Chaque pôle comprend une plage de connexion primaire 22 et une plage de connexion secondaire 23.

Chaque pôle est configuré pour recevoir un courant électrique I sur la plage primaire 22 et pour délivrer le courant I sur la plage secondaire 23, et vice-versa.

Chaque plage 22, 23 est propre à recevoir une extrémité d'un conducteur 7A, 7B, 8A, 8B.

Chaque plage de connexion primaire 22 est portée par une première face terminale 20, à savoir la face supérieure. Chaque plage de connexion secondaire 23 est portée par la deuxième face terminale 20, à savoir la face inférieure.

Deux connecteurs 10 sont montés sur la face terminale supérieure 20 et relient entre elles chacun deux plages de connexion primaire 22.

Chaque conducteur d'entrée 7A, 7B est un câble électrique relié électriquement à une pluralité d'installations électriques IE.

Sur la figure 1, chaque conducteur d'entrée 7A, 7B est relié électriquement à trois installations électriques IE, par exemple, trois installations photovoltaïques de production d'électricité.

Chaque installation IE est reliée électriquement au premier conducteur d'entrée 7A et au deuxième conducteur d'entrée 7B. De préférence, chaque installation électrique IE est propre à imposer une différence de potentiel entre le premier conducteur d'entrée 7A et le deuxième conducteur d'entrée 7B.

Chaque conducteur de sortie 8A, 8B est un câble électrique relié à un réseau de distribution d'électricité (non représenté).

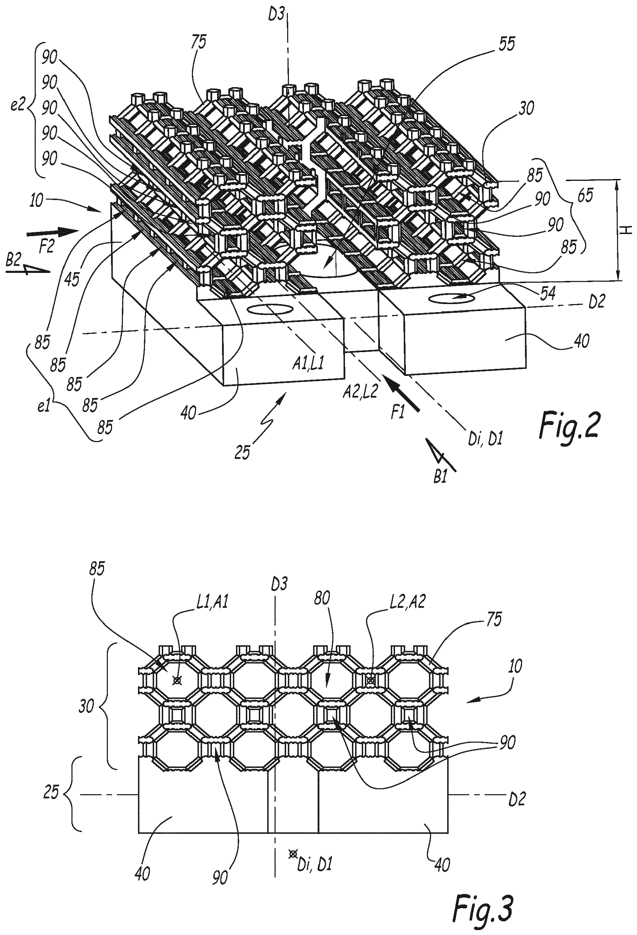

L'invention est décrite ci-dessus dans le cas de son utilisation pour connecter électriquement entre elles deux plages de connexion primaires 22 de la face terminale supérieure 20. Elle est toutefois applicable également pour connecter électriquement entre elles deux plages de connexion secondaires 23 de la face terminale inférieure 20. Le connecteur 10 est représenté sur les figures 2 et 3.

Ce connecteur 10 est mobile par rapport au disjoncteur 5 entre une position de déconnexion et au moins une position de connexion. De préférence, le connecteur 10 est mobile en translation selon une direction d'insertion Di entre la position de connexion et l'au moins une position de déconnexion.

Le connecteur 10 est configuré pour connecter électriquement deux plages de connexion primaires 22 ou deux plages de connexion secondaires 23 voisines du disjoncteur 5 lorsque le connecteur 10 est en position de connexion.

Le connecteur 10 est, en outre, propre à refroidir le disjoncteur 5 par échange thermique avec l'atmosphère. Par exemple, le connecteur 10 est propre à refroidir le disjoncteur 5 par échange thermique spontané avec l'atmosphère, notamment par convection. En variante, le connecteur 10 est propre à refroidir le disjoncteur 5 par échange thermique forcé avec l'atmosphère, par exemple par l'utilisation d'un ventilateur dirigeant un flux d'air vers le connecteur 10.

Le connecteur 10 comprend une portion de conduction 25, une couche conductrice, une couche de passivation et une portion de dissipation 30.

Le connecteur 10 est monobloc. Cela signifie que la portion de conduction 25 et la portion de dissipation 30 partagent une âme commune.

La portion de conduction 25 comporte deux bornes 40 et un corps 45.

La portion de conduction 25 présente une première face 47 et une deuxième face 48 opposée à la première face 47. De préférence, la première face 47 et la deuxième face 48 sont parallèles.

Lorsque le connecteur 10 est en position de connexion, la deuxième face 48 est orientée en direction de la face avant 17. De préférence, la deuxième face 48 est sensiblement parallèle à la face avant 17.

Le capot 15 est fixé de manière amovible au disjoncteur 5.

Le capot 15 est propre à empêcher l'accès, par un opérateur, aux connecteurs 10 lorsque le capot 15 est fixé au disjoncteur 5 et que les connecteurs 10 sont en position de connexion.

La base arrière 12 et le capot 15 sont configurés pour, lorsqu'ils sont fixés l'un à l'autre, recouvrir au moins partiellement chaque connecteur 10. La base arrière 12 et le capot 15 sont, par exemple, fixés l'un à l'autre par une première vis 38.

La portion de conduction 25 est propre à recevoir le courant I au niveau de l'une des bornes 40, et à délivrer le courant électrique à l'autre borne 40.

L'âme est, en outre, commune au corps 45 et aux bornes 40.

L'âme est réalisée en un premier matériau M1. Le premier matériau M1 est un électriquement et thermiquement conducteur. De préférence, le premier matériau M1 est un matériau métallique.

Le premier matériau M1 est avantageusement l'aluminium. En variante, le premier matériau M1 est le cuivre. Selon une autre variante, le premier matériau M1 est le nickel. Le premier matériau M1 présente une première émissivité $\varepsilon 1$ dont la valeur est comprise entre 0.02 et 0.9.

L'émissivité d'un matériau est définie comme étant le rapport entre l'énergie rayonnée par le matériau et l'énergie rayonnée par un corps noir à la même température.

Chaque borne 40 est propre à être connectée électriquement à une plage de connexion 22, 23 lorsque le connecteur 10 est en position de connexion.

Lorsque le connecteur 10 est en position de déconnexion, ses bornes 40 ne sont pas connectées électriquement à une plage 22, 23.

Chaque borne 40 est parallélépipédique. Chaque borne 40 présente un trou 54 de réception d'une deuxième vis de fixation (non représentée). La deuxième vis est propre à fixer la borne 40 à la plage 22, 23 lorsque le connecteur 10 est en position de connexion.

Le corps 45 est propre à conduire le courant électrique I entre une borne 40 et l'autre borne 40.

Le corps 45 est parallélépipédique.

Le corps 45 présente un trou 55 de passage de la première vis 38. Le trou de passage 55 est cylindrique, autour d'un axe perpendiculaire à la première face 47. Le trou de passage 55 est cylindrique à base ovale.

La couche conductrice est propre à protéger l'âme de la borne 40 contre la corrosion. La couche conductrice est, en outre, propre à assurer une bonne connexion électrique entre l'âme et la borne de connexion 22, 23.

La couche conductrice recouvre au moins en partie l'âme de la borne 40. De préférence, la couche conductrice recouvre totalement l'âme de la borne 40.

La couche conductrice est réalisée en un matériau électriquement conducteur. Par exemple, la couche conductrice est réalisée en un matériau métallique, tel que l'argent. En variante, la couche conductrice est réalisée en étain.

La couche conductrice présente une première épaisseur e1. La première épaisseur e1 est comprise entre 500 nanomètres et 50 micromètres, par exemple, égale à 15 micromètres ($\mu$m).

La couche de passivation est propre à protéger l'âme du corps 45 et l'âme de la portion de dissipation 30 contre la corrosion. La couche de passivation est, en outre, propre à augmenter les échanges thermiques de la portion de dissipation 30 avec l'atmosphère par rayonnement, par rapport à la même portion de dissipation 30 ne comportant pas de couche de passivation.

La couche de passivation recouvre au moins en partie l'âme du corps 45 et l'âme de la portion de dissipation 30. De préférence, la couche de passivation recouvre en totalité l'âme du corps 45 et l'âme de la portion de dissipation 30.

La couche de passivation est réalisée en un deuxième matériau M2.

Le deuxième matériau M2 est électriquement isolant.

Le deuxième matériau M2 présente une deuxième émissivité $\varepsilon$2. La deuxième émissivité $\varepsilon$2 est supérieure ou égale à la première émissivité $\varepsilon$1. De préférence, la deuxième émissivité $\varepsilon$2 est strictement supérieure à la première émissivité $\varepsilon$1.

En particulier, la deuxième émissivité $\varepsilon$2 est comprise entre 0,6 et 0,9.

De préférence, la deuxième émissivité $\varepsilon$2 est supérieure ou égale à 0.75, de préférence à 0.85.

Le deuxième matériau M2 est avantageusement l'alumine $Al_2O_3$. Par exemple, lorsque l'âme est réalisée en aluminium, la couche de deuxième matériau M2 est obtenue par anodisation.

La couche de deuxième revêtement présente une deuxième épaisseur e2. La deuxième épaisseur e2 est comprise entre 5 $\mu$m et 20 $\mu$m.

En variante, le deuxième matériau M2 est un matériau polymère présentant une deuxième émissivité $\varepsilon$2 strictement supérieure à la première émissivité $\varepsilon$1, tel qu'un matériau polymère noir mat. Le deuxième matériau M2 est, par exemple, un polyuréthane, de préférence un polyuréthane bicomposant obtenu par réticulation d'un isocyanate Dans ce cas, la deuxième épaisseur e2 est strictement inférieure à 1 millimètre (mm).

La portion de dissipation 30 est propre à augmenter les pertes d'énergie thermiques, par conduction, par convection et par rayonnement, par rapport au même connecteur 10 ne comportant pas de portion de dissipation 30.

La portion de dissipation 30 est propre à être traversée par un premier flux F1 d'un fluide F et par au moins un deuxième flux F2 du fluide F.

Le fluide F est, par exemple, l'air.

Le premier flux F1 et le deuxième flux F2 sont, par exemple des flux spontanés, tels que des flux convectifs ou des flux générés par le vent. En variante, le premier flux F1 et le deuxième flux F2 sont générés artificiellement, par exemple par un ventilateur.

Le premier flux F1 est orienté selon une première direction D1. Par exemple, la première direction D1 est parallèle à la direction d'insertion Di.

Le deuxième flux F2 est orienté selon une deuxième direction D2. La deuxième direction D2 est perpendiculaire à la première direction D1.

Par exemple, la deuxième direction D2 est parallèle à la deuxième face 48.

La portion de dissipation 30 présente une structure alvéolaire. Cela signifie que la portion de dissipation 30 définit une pluralité d'alvéoles 65. Comme expliqué ci-après, les alvéoles 65 sont de deux types ; à savoir des alvéoles d'un premier type 85 et des alvéoles d'un deuxième type 90.

La portion de dissipation 30 présente une hauteur H selon une troisième direction D3. La hauteur H est représentée sur la figure 2. La troisième direction D3 est perpendiculaire à la deuxième face 48. De préférence, la troisième direction D3 est, en outre, perpendiculaire à la direction d'insertion Di.

La hauteur H est inférieure ou égale à 45 millimètres (mm). Par exemple, la hauteur H est égale à environ 30 mm. Il est entendu par l'expression « égale à environ 30 mm » que la hauteur H est égale à 30 mm, à 10 pourcents près.

La portion de dissipation 30 et le corps 45 sont superposés suivant la troisième direction D3.

Chaque alvéole 65 présente un volume individuel Vi.

Il est défini un volume total Vt comme étant la somme des volumes individuels Vi de chaque alvéole 65.

La portion de dissipation 30 présente un premier volume V1. Le premier volume V1 est défini comme étant le volume de matériau composant la portion de dissipation 30. C'est-à-dire que le premier volume V1 est la somme du volume de l'âme de la portion de dissipation 30, du volume de la couche de passivation, et du volume total Vt. Il est défini, pour la portion de dissipation 30, une porosité P. La porosité P est définie comme étant le rapport entre, au numérateur, le volume total Vt des alvéoles 65, et, au dénominateur, le premier volume V1. Cela s'écrit mathématiquement :

$$P = \frac{Vt}{V1}$$

La porosité P est supérieure ou égale à 50 pourcents (%). La porosité P est avantageusement strictement supérieure à 75 %, de préférence supérieure ou égale à 85 %.

Par exemple, la portion de dissipation 30 est formée par la réunion d'une pluralité de segments 75.

Chaque segment 75 est sensiblement rectiligne.

Chaque segment 75 est connecté à au moins un autre segment 75. Par exemple, le segment 75 est connecté à l'une de ses extrémités à l'autre segment 75.

Chaque alvéole 65 est de forme polyédrique.

Un polyèdre est une forme géométrique à trois dimensions ayant des facettes planes polygonales qui se rencontrent selon des segments de droite appelés arêtes.

Par exemple, chaque alvéole 65 est délimitée par un sous-ensemble primaire SE1 de segments 75 et la réunion des segments 75 du sous-ensemble primaire SE1 forme un polyèdre dont chaque segment 75 définit une arête.

Chaque facette de l'alvéole 65 est définie par un sous-ensemble secondaire SE2 de segments 75.

Chaque alvéole 65 présente au moins une ouverture 80. Par exemple, l'ouverture 80 est délimitée par le sous-ensemble secondaire SE2 de segments 75.

L'ouverture 80 est propre à connecter entre elles une première alvéole 65 et une deuxième alvéole 65.

Par exemple, la première alvéole 65 est délimitée par un premier sous-ensemble primaire SE1, la deuxième alvéole 65 est délimitée par un deuxième sous-ensemble primaire SE1 et le sous-ensemble secondaire SE2 est inclus à la fois dans le premier sous-ensemble primaire SE1 et dans le deuxième sous-ensemble primaire SE1.

L'ouverture 80 est configurée pour permettre la circulation du fluide F depuis la première alvéole 65 jusqu'à la deuxième alvéole 65. Les ouvertures 80 permettent donc la conduction de la chaleur au sein de la structure alvéolaire.

Chaque ouverture 80 présente un diamètre D.

Le diamètre D d'une ouverture 80 est le diamètre du cercle inscrit dans cette ouverture 80. En géométrie, un cercle inscrit à un polygone est un cercle qui est tangent par l'intérieur à tous les côtés de ce polygone. De manière plus générale, on parle de cercle inscrit dans une surface bornée pour indiquer un cercle de plus grand rayon possible inclus dans la surface.

Le diamètre D est, par exemple, compris strictement entre 6 mm et 10 mm.

Par exemple, la première alvéole 65 présente au moins une première ouverture 80 et une deuxième ouverture 80. Cela signifie que l'alvéole 65 est connectée à au moins la deuxième alvéole 65 et une troisième alvéole 65.

L'alvéole 65 est propre à être traversée par un flux du fluide F. Cela signifie que la première ouverture 80 est ménagée dans une première facette de la première alvéole 65 et que la deuxième ouverture 80 est ménagée dans une deuxième facette distincte de la première facette.

De préférence, la première facette et la deuxième facette sont parallèles entre elles.

Avantageusement, la première facette et la deuxième facette sont face à face. Cela signifie qu'une droite reliant le centre de la première facette au centre de la deuxième facette est perpendiculaire à la première facette et à la deuxième facette.

Par exemple, la droite reliant le centre de la première facette au centre de la deuxième facette est parallèle à la première direction D1. Cela signifie que l'alvéole 65 est propre à être traversée par le premier flux F1.

L'alvéole 65 présente, en outre, une troisième ouverture 80 et une quatrième ouverture 80. Cela signifie que l'alvéole 65 est connectée à au moins deux autres alvéoles 65 en plus des deuxième et troisième alvéoles 65 mentionnées ci-dessus.

La troisième ouverture 80 est ménagée dans une troisième facette, et la quatrième ouverture 80 est ménagée dans une quatrième facette opposée à la troisième facette.

Par exemple, la droite reliant le centre de la troisième facette au centre de la quatrième facette est parallèle à la deuxième direction D2. Cela signifie que l'alvéole 65 est propre à être traversée par le deuxième flux F2.

De préférence, chaque facette de l'alvéole 65 présente une ouverture 80.

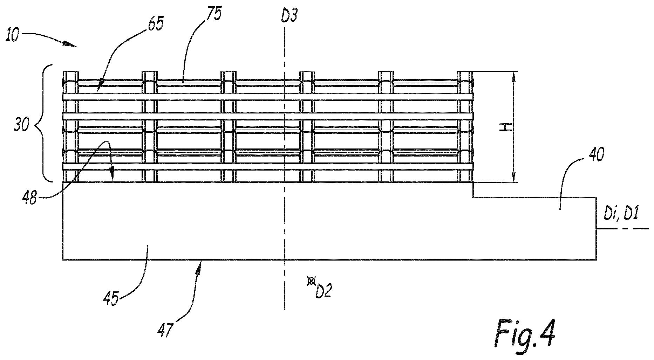

Comme représenté sur les figures 2 à 4 et comme mentionné ci-dessus, la portion de dissipation 30 définit un premier ensemble d'alvéoles 85 d'un premier type et un deuxième ensemble d'alvéoles 90 d'un deuxième type. Ainsi, chaque alvéole 65 est soit une alvéole du premier type 85 soit une alvéole du deuxième type 90.

Le premier ensemble est formé par la réunion d'une pluralité de premiers sous-ensembles e1 d'alvéoles du premier type 85.

Chaque premier sous-ensemble e1 présente une première ligne propre L1. La première ligne propre L1 est rectiligne. La première ligne propre L1 est parallèle à la première direction D1.

Les alvéoles du premier type 85 de chaque premier sous-ensemble e1 sont alignées entre elles le long de la première ligne propre L1. Par exemple, chaque alvéole du premier type 85 est cylindrique autour d'un premier axe A1, et le deuxième axe A1 est confondu avec la première ligne propre L1.

L'alvéole du premier type 85 est cylindrique à base octogonale. La base de l'alvéole du premier type 85 est un octogone régulier.

Comme visible sur la figure 3, les alvéoles du premier type 85 forment, dans un plan perpendiculaire à la première direction D1, un premier réseau périodique à base carrée.

Chaque alvéole du premier type 85 est définie, selon la deuxième direction D2, par au moins une alvéole du deuxième type 90. De préférence, l'alvéole du premier type 85 est définie, selon la deuxième direction D2, par deux alvéoles du deuxième type 90.

Chaque alvéole du premier type 85 est définie, selon la troisième direction D3, par au moins une alvéole du deuxième type 90. De préférence, l'alvéole du premier type 85 est définie, selon la troisième direction D3, par deux alvéoles du deuxième type 90.

Deux arêtes de l'alvéole du premier type 85 sont parallèles à la deuxième direction D2, et deux arêtes sont perpendiculaires à la deuxième direction D2.

La base de l'alvéole du premier type 85 définit une facette terminale. La facette terminale présente une ouverture terminale. Le diamètre de l'ouverture terminale est, par exemple, strictement inférieur à 10 mm.

Le deuxième ensemble comprend une pluralité de deuxièmes sous-ensembles e2 d'alvéoles du deuxième type 90.

Chaque deuxième sous-ensemble e2 présente une deuxième ligne propre L2.

La deuxième ligne propre L2 est rectiligne. La deuxième ligne propre L2 est parallèle à la première direction D1.

Les alvéoles du deuxième type 90 de chaque deuxième sous-ensemble e2 sont alignées entre elles le long de la deuxième ligne propre L2. Par exemple, chaque alvéole deuxième type 90 est cylindrique autour d'un deuxième axe A2, et le deuxième axe A2 est confondu avec la deuxième ligne propre L2.

L'alvéole du deuxième type 90 est cylindrique à base carrée.

Les alvéoles du deuxième type 90 forment, dans un plan perpendiculaire à la première direction D1, un deuxième réseau périodique à base carrée.

Chaque alvéole du deuxième type 90 est définie, selon la deuxième direction D2, par au moins une alvéole du premier type 85. De préférence, l'alvéole du deuxième type 90 est définie, selon la deuxième direction D2, par deux alvéoles du premier type 85.

Chaque alvéole du deuxième type 90 est définie, selon la troisième direction D3, par au moins une alvéole du premier type 85. De préférence, l'alvéole du deuxième type 90 est définie, selon la troisième direction D3, par deux alvéoles du premier type 85.

De préférence, l'alvéole du deuxième type 90 est définie, selon un plan perpendiculaire à la première direction D1, par quatre alvéoles du premier type 85 avec lesquelles elle partage ses arêtes.

Le connecteur 10 permet une dissipation de chaleur plus efficace que dans les connecteurs de l'état de la technique, à la fois par conduction, par convection et par rayonnement.

De plus, la dissipation thermique étant plus efficace, le connecteur 10 est réalisé en aluminium, plus résistif électriquement mais moins cher et plus léger que les matériaux utilisés dans les connecteurs de l'état de la technique.

Enfin, le connecteur 10 permet une dissipation efficace de la chaleur même lorsque le disjoncteur 5 n'est pas vertical. Par exemple, le connecteur 10 permet une dissipation efficace de la chaleur lorsque la première direction D1 n'est pas direction verticale. Le connecteur 10 est donc plus adaptable aux conditions d'installation du disjoncteur 5 que les connecteurs de l'état de la technique. Les ouvertures des alvéoles des deux types 85, 90 sont alignées selon la première direction D1 et selon la deuxième direction D2. Les pertes de charge lors de la traversée de la portion de dissipation par le premier flux F1 et par le deuxième flux F2 sont donc plus faibles. L'échange thermique entre la portion de dissipation et l'atmosphère est donc amélioré. Le connecteur 10 permet donc une dissipation thermique plus efficace, en particulier lorsque la deuxième direction D2 est une direction verticale.

L'invention est décrite ci-dessus dans le cas de son utilisation pour un disjoncteur. Elle est toutefois applicable avec d'autres types d'appareils électriques, notamment des appareillages basse tension de protection et de commande.

Le mode de réalisation et les variantes envisagés ci-dessus peuvent être combinés entre eux pour générer de nouveaux modes de réalisation de l'invention, dans le cadre de l'invention défini par les revendications.

## Revendications

1. Connecteur électrique (10) comportant une portion de conduction (25) comprenant deux bornes (40) destinées à être chacune connectées électriquement à une borne de connexion (22, 23) d'un appareil électrique (5),
   le connecteur (10) comprenant, en outre, une portion de dissipation (30) venue de matière avec la portion de conduction (25) et présentant une structure alvéolaire définissant une pluralité d'alvéoles (65, 85, 90),
   **caractérisé en ce que** :

   - la portion de dissipation (30) délimite un premier ensemble d'alvéoles d'un premier type (85) et un deuxième ensemble d'alvéoles d'un deuxième type (90), et
   - les alvéoles du premier type (85) sont cylindriques à base octogonale, et les alvéoles du deuxième type (90) sont cylindriques à base carrée,

   chaque alvéole (65, 85, 90) étant propre à être traversée par un premier flux (F1) de fluide (F) orienté selon une première direction (D1), chaque alvéole (65, 85, 90) étant propre à être traversée par le premier flux (F1) et par un deuxième flux (F2) de fluide (F) orienté selon une deuxième direction (D2) perpendiculaire à la première direction (D1), chaque alvéole (65 ; 85, 90) étant connectée à au moins une autre alvéole (65, 85, 90) à travers une ouverture (80) permettant la circulation d'un fluide (F) d'une alvéole (65 ; 85, 90) à l'autre, les ouvertures des alvéoles des deux types (85, 90) étant alignées selon la première direction (D1) et selon la deuxième direction (D2).

2. Connecteur (10) selon la revendication 1, dans lequel la portion de dissipation (30) présente une porosité supérieure ou égale à 50 %, de préférence à 75 %, de préférence encore à 85%.

3. Connecteur (10) selon la revendication 1 ou 2, dans lequel la portion de conduction (25) est réalisée au moins partiellement en métal, de préférence en aluminium.

4. Connecteur (10) selon l'une quelconque des revendications 1 à 3, comportant une âme réalisée en un premier matériau (M1) présentant une première émissivité ($\epsilon$1), dans lequel la portion de dissipation (30) comporte une couche de passivation réalisée en un deuxième matériau (M2) présentant une deuxième émissivité ($\epsilon$2) supérieure ou égale, de préférence strictement supérieure à la première émissivité ($\epsilon$1).

5. Connecteur (10) selon l'une quelconque des revendications 1 à 4, dans lequel :

- le premier ensemble comprend une pluralité de premiers sous-ensembles (e1) d'alvéoles du premier type (85), le deuxième ensemble comprend une pluralité de deuxièmes sous-ensembles (e2) d'alvéoles du deuxième type (90), chaque premier sous-ensemble (e1) et chaque deuxième sous-ensemble (e2) présentant une ligne propre (L1, L2) respective, et
- les alvéoles (85, 90) de chaque sous-ensemble (e1, e2) sont agencées le long de la ligne propre (L1, L2) du sous-ensemble (e1, e2) et l'axe (A1, A2) de chaque alvéole (85, 90) est la ligne propre (L1, L2).

6. Appareil électrique, notamment disjoncteur, (5) équipé d'un connecteur (10) selon l'une quelconque des revendications précédentes.

**Patentansprüche**

1. Elektrischer Verbinder (10), umfassend einen leitenden Abschnitt (25), der zwei Klemmen (40), jeweils zum elektrischen Anschließen an eine Anschlussklemme (22, 23) eines elektrischen geräts (5), umfasst, wobei der Verbinder (10) ferner einen Dissipationsabschnitt (30) umfasst, der mit dem leitenden Abschnitt (25) integriert ist und eine Wabenstruktur aufweist, die eine Mehrzahl Waben (65, 85, 90) definiert, **dadurch gekennzeichnet, dass**:

- der Dissipationsabschnitt (30) eine erste Gruppe von Waben einer ersten Art (85) und eine zweite Gruppe von Waben einer zweiten Art (90) definiert und

- die Waben der ersten Art (85) zylindrisch sind und eine achteckige Basis aufweisen, und die Waben der zweiten Art (90) zylindrisch sind und eine viereckige Basis aufweisen,

wobei jede Wabe (65, 85, 90) geeignet ist, durch eine erste Strömung (F1) eines Fluids (F) überquert zu werden, die eine erste Ausrichtung (D1) aufweist, wobei jede Wabe (65, 85, 90) geeignet ist, durch die erste Strömung (F1) und durch eine zweite Strömung (F2) eines Fluids überquert zu werden, die eine zweite, senkrecht zur ersten Ausrichtung (D1) verlaufende Ausrichtung (D2) aufweist, wobei jede Wabe (65 ; 85, 90) über eine Öffnung (80), die die Zirkulation eines Fluids (F) von einer Wabe (65 ; 85; 90) in eine andere ermöglicht, mit mindestens einer anderen Wabe verbunden ist, wobei die Öffnungen der Waben der beiden Arten (85, 90) die erste Ausrichtung (D1) und die zweite Ausrichtung (D2) aufweisen.

2. Verbinder (10) nach Anspruch 1, wobei der Dissipationsabschnitt (30) eine Porosität aufweist, die höher oder gleich 50 %, insbesondere 75 %, besonders bevorzugt 85 % ist.

3. Verbinder (10) nach Anspruch 1 oder 2, wobei der leitenden Abschnitt (25) mindestens zum Teil aus Metall, vorzugsweise aus Aluminium, besteht.

4. Verbinder (10) nach einem der Ansprüche 1 - 3, umfassend einen Kern, der aus einem ersten Material (M1) besteht und einen ersten Emissionsgrad ($\epsilon$1) aufweist, wobei der Dissipationsabschnitt (30) eine Passivierungsschicht umfasst, die aus einem zweiten Material (M2) besteht und einen zweiten Emissionsgrad ($\epsilon$2) aufweist, der höher oder gleich, vorzugsweise höher ist als der erste Emissionsgrad ($\epsilon$1).

5. Verbinder (10) nach einem der Ansprüche 1 - 4, wobei:

- die erste Gruppe eine Mehrzahl Untergruppen (e1) von Waben der ersten Art (85) umfasst, die zweite Gruppe eine Mehrzahl zweiter Untergruppen (e2) von Waben der zweiten Art (90) umfasst, wobei jede erste Untergruppe (e1) und jede zweite Untergruppe (e2) eine jeweils eigene Leitung (L1, L2) aufweist, und
- die Waben (85, 90) jeder Untergruppe (e1, e2) entlang der eigenen Leitung (L1, L2) der Untergruppe (e1, e2) angeordnet sind und die Achse (A1, A2) jeder Wabe (85, 90) die eigene Leitung (L1, L2) ist.

6. Elektrisches Gerät, insbesondere Leistungsschalter (5), das mit einem Verbinder (10) nach einem der vorstehenden Ansprüche ausgerüstet ist.

**Claims**

1. An electrical connector (10) including a conducting portion (25) comprising two terminals (40) each intended to be electrically connected to a connecting terminal (22, 23) of an electrical apparatus (5), the connector (10) further comprising a dissipating portion (30) integral with the conducting portion (25) and having a honeycomb structure defining a plurality of cells (65, 85, 90), **characterized in that**:

   - the dissipating portion (30) delimits a first set of cells of a first type (85) and a second set of cells of a second type (90), and
   - the cells of the first type (85) are cylindrical with an octagonal base, and the cells of the second type (90) are cylindrical with a square base,

   each cell (65, 85, 90) being able to be traversed by a first flow (F1) of fluid (F) oriented in a first direction (D1), each cell (65, 85, 90) being able to be traversed by the first flow (F1) and by a second flow (F2) of fluid (F) oriented in a second direction (D2) perpendicular to the first direction (D1), each cell (65; 85, 90) being connected to at least one other cell (65, 85, 90) through an opening (80) allowing the flow of a fluid (F) from one cell (65; 85, 90) to the other, the openings of the cells of both types (85, 90) being aligned in the first direction (D1) and in the second direction (D2).

2. The connector (10) according to claim 1, wherein the dissipating portion (30) has a porosity greater than or equal to 50%, preferably 75%, still more preferably 85%.

3. The connector (10) according to claim 1 or 2, wherein the conducting portion (25) is made at least partially from metal, preferably from aluminum.

4. The connector (10) according to any one of claims 1 to 3, including a core made from a first material (M1) having a first emissivity ($\varepsilon$1), in which the dissipating portion (30) includes a passivation layer made from a second material (M2) having a second emissivity ($\varepsilon$2) greater than or equal to, preferably strictly greater than, the first emissivity ($\varepsilon$1).

5. The connector (10) according to any one of claims 1 to 4, wherein:

   - the first set comprises a plurality of first subsets (e1) of cells of the first type (85), the second set comprising a plurality of second subsets (e2) of cells of the second type (90), each first subset (e1) and each second subset (e2) having a respective specific line (L1, L2), and
   - the cells (85, 90) of each subset (e1, e2) are arranged along the specific line (L1, L2) of the subset (e1, e2) and the axis (A1, A2) of each cell (85, 90) is the specific line (L1, L2).

6. An electrical apparatus, in particular a circuit breaker, (5) equipped with a connector (10) according to any one of the preceding claims.

Fig.1

Fig.2

Fig.3

Fig.4

**EP 3 176 881 B1**

## RÉFÉRENCES CITÉES DANS LA DESCRIPTION

### Documents brevets cités dans la description

- CN 204011306 U